Europäisches Patentamt

European Patent Office

Office européen des brevets

(19)

(11) Publication number: **0 013 392**

**A1**

(12) **EUROPEAN PATENT APPLICATION**

(21) Application number: **79105269.9**

(22) Date of filing: **19.12.79**

(51) Int. Cl.³: **H 04 R 3/14**
**H 03 H 3/00**

(30) Priority: **22.12.78 JP 159436/78**

(43) Date of publication of application:
**23.07.80 Bulletin 80/15**

(84) Designated Contracting States:
**BE DE FR GB IT NL SE**

(71) Applicant: **Jelmax Co., Ltd**
**Rm. 1005 DK Bldg 5-4, Shinbashi 6 Chome**
**Minato-ku Tokyo(JP)**

(72) Inventor: **Hideo, Kurose**
**11-45, Kotsubo 7-chome**
**Zushi-shi, Kanagawa-ken(JP)**

(74) Representative: **Eitle, Werner, Dipl.-Ing. Dipl.-Ing.**
**Werner Eitle Dr. rer. nat. Klaus Hoffmann et al,**
**Dipl.-Ing. Werner Lehn Dipl.-Ing. Klaus Füchsle Dr. rer.**
**nat. Bernd Hansen Arabellastrasse 4**
**D-8000 München 81(DE)**

(54) **Dividing network.**

(57) A dividing network in order to be compatible with the impedance of the line or load and to fit to an arbitrary crossover frequency comprises a dividing network element (24) formed by winding a pair of strip members (22a, 22b) of high electro-conductivity arranged opposedly to each other with a dielectric member interposed (21a), 21b) therebetween, inductance formed in said wound strip members (22a, 22b), capacitance formed between said strip members (22a, 22b) and a plurality of terminals (27, 28, 29, 30) selectively led out from the end portions (25a, 25b, 26a) or other portion of said pair of the strip members (22a, 22b).

FIG. 5

(A)          (B)

EP 0 013 392 A1

- 1 -

Dividing network

The present invention relates to a dividing network
for dividing audio signal and high frequency signal
into signals of different frequency bands by a predetermined crossover frequency and distributing and
providing the divided signals to audio equipments such
as a plurality of speakers and electric equipments
having predetermined load impedance or line impedance.

Conventional reproduction equipments for audio signals
operate by dividing output signal from audio amplifier
into signals of different frequency bands by a predetermined crossover frequency, and distributing the
divided signals to a plurality of speakers having
different performance of audio reproduction such as
woofer, tweeter, etc. which are assigned so as to enable
excellent audio reproduction over the whole audio
frequency bands. For this purpose, it is necessary to
provide a dividing network which is able to divide audio
signals correspondingly to the frequency bands specific
to each of the speakers.

The performances of the dividing network have a significant correlation with the reproduction efficiency and
tone quality in the speaker system. Generally, a filter
circuit is used as the frequency dividing circuit, which comprises a combination of inductance composed of a coil with hollow or iron core of approximately 0.1 mH to 4 mH made by winding a number of times a coated conductive wire of 0.5 to 2.5 mm in diameter and a capacitance composed of a capacitor of 1 to 50 µF so as to make the load impedance as a predetermined value at the predetermined crossover frequency. The constituting elements of the circuit, especially the capacitor element, generate a large number of harmonics and parasitic resonance that are caused by non-linear factor present therein and residual inductance and the like. The coil entails undesirable distributed capacity, resulting also in parasitic resonance, and moreover, it oscillates as the signal current passes generating higher harmonics. These high frequency factors inter act with one another to cause cross modulation, generating undesirable distorted signals which will greatly change the spectrum of the audio signals and give negative influence on the fidelity and tone quality of the reproduced acoustic sounds.

Moreover, capacitor elements that are generally used in these circuits often employ vapor metalized electrode and the like in order to make the whole system compact. This causes great loss in the passing audio signals and results in decrease of efficiency in the speaker system of the acoustic reproduction. It is heretofore difficult to obtain predetermined attenuation characteristics.

When in the higher frequency regions, for example, in case of a coaxial cable of low impedance in the range of 50 to 75 $\Omega$, the distributed capacity of said coil and the residual inductance of the capacitor will have markedly greater influence. Even if these values are as predetermined for each element, they will be subject to the above-mentioned influence and will thus deviate from the original desired value. It has been a drawback that it is extremely difficult to produce a network which has a desirable frequency attenuation characteristics unless, in most cases, an extensive readjustment of the values is conducted.

The present invention is to provide a novel improved dividing network which is suitable for lines and load device having relatively low impedance of not more than several hundreds has extremely small loss and less non-linear factors, stands great electric power and in which the values of inductance and capacitance of each dividing network element can be integrated in a single element substantially in accordance with the desired value.

According to this invention, there is provided a dividing network comprising a dividing network element formed by winding a pair of strip members of high electro-conductivity arranged opposedly to each other with a dielectric member interposed therebetween, inductance formed in said wound strip members, capacitance formed between said strip members, and a plurality of terminals selectively led out from the end portions or other portion of said pair of the strip members.

The primary object of the present invention is to provide a dividing network which is compatible with the impedance of the line or load and fits to an arbitrary crossover frequency.

Another object of the present invention is to provide a dividing network element in which given inductance and capacitance are integrated as one body by winding a

0013392

- 4 -

pair of high electro-conductive strips that are arranged in parallel with a dielectric member being interposed therebetween.

Further object of the present invention is to provide a dividing network element in which the floating capacity of the coil and the residual inductance of the capacitor are made substantially zero.

Still further object of the present invention is to provide a dividing network of high performance which is capable of dividing audio signal into a plurality of signals of different frequency bands and distributing them to corresponding number of speakers.

Still further object of the present invention is to provide an integrated dividing network element having identical cross frequency and substantially identical attenuation characteristics in the high and low frequency bands.

Still further object of the present invention is to provide a novel dividing network element which is made compatible with the high frequency coaxial cable and which allows or precludes certain frequency bands.

Figs. 1 and 2 show circuit diagrams of a dividing network which is suitable for speaker circuit;

Fig. 3 shows a component material for the network according to the present invention wherein Fig. 3(A) is a schematical perspective view thereof and (B) is a longitudinal cross sectional view of (A);

Fig. 4 is a schematical perspective view showing a network element which constitutes the dividing network of the present invention;

Fig. 5(A) is a view showing the connection diagram when the said network element is used in a filter circuit for high frequency band: Fig. 5(B) shows the equivalent circuit diagram of Fig. 5(A);

Fig. 6(A) illustrates a connection diagram when the network element is used in a filter circuit for low frequency band: Fig. 6(B) shows the equivalent circuit diagram of Fig. 6(A); and

Fig. 7 is a graphic representation to show transmission/attenuation characteristics of the network element of this invention.

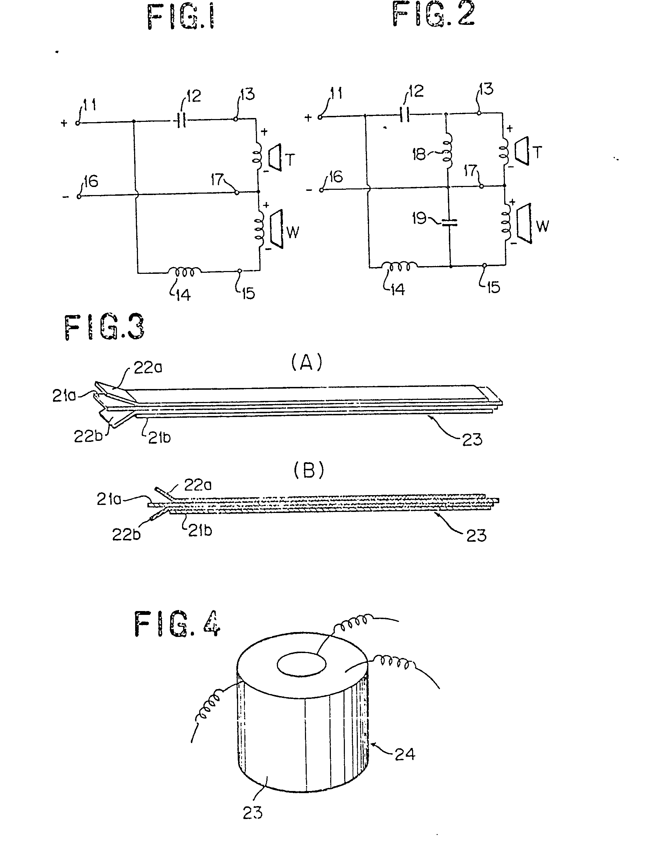

For better understandings of the invention, an employment of a dividing network will be described in terms of speaker system. In Fig. 1 is shown a dividing network of parallel connection with one element employed in so-called two-way speaker system which operates by dividing one audio signal into signals of high frequency band and low frequency band and reproducing acoustic sound from speakers, tweeter and woofer, having frequency characteristics which correspond to said frequency bands.

Audio signal on the positive side is led in from input terminal 11 and led to the positive output terminal 13 for leading out the signals of high frequency band via capacitor 12 while at the same time it is connected to positive output terminal 15 for leading out the signals of low frequency band via coil 14.

The negative input terminal 16 for said audio signal is directly connected to the negative output terminal 17 common to said output terminals 13 and 15.

Speakers for tweeter T and woofer W are connected between the output terminals 13 and 17 and between 15 and 17 respectively. Here, the capacitance $C_1$ of said capacitor 12 and the inductance $L_1$ of the coil 14 are the factors to determine the crossover frequency for high frequency band and low frequency band that are to be divided and established, and they are indicated by the following equations:

$$C_1 = \frac{1}{2 \pi f_0 R_0} \qquad \text{(F: Farad)}$$

$$L_1 = \frac{R_0}{2 \pi f_0} \qquad \text{(H: Henry)}$$

wherein $f_0$: crossover frequency (Hz)

$R_0$: impedance of each speaker ($\Omega$)

Therefore, by so determining the crossover frequency between the high and low frequency bands as in accordance with the frequency characteristics of the speakers to be used, the capacitance and inductance which comprise the network elements can be determined to set the network attenuation characteristics at octave/6 db.

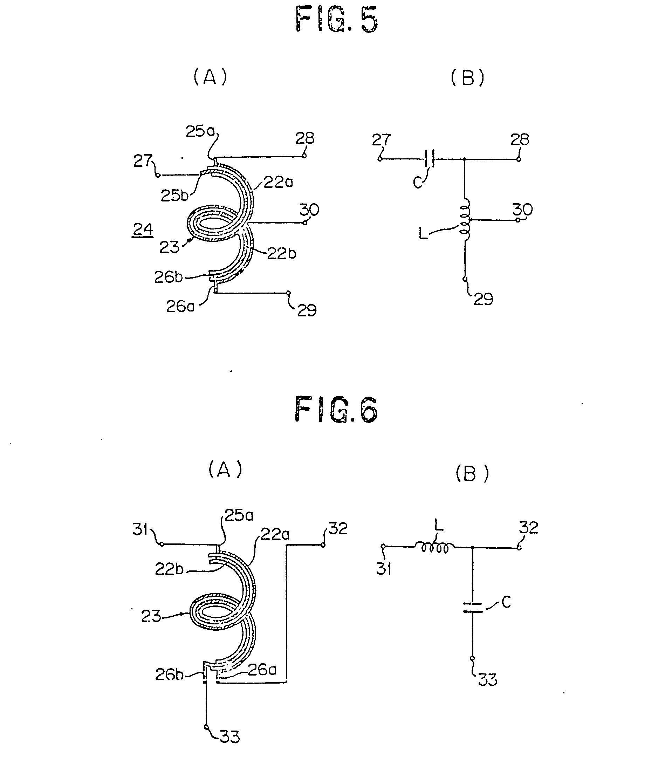

Fig. 2 shows a circuit diagram of a dividing network of parallel connection with two elements in which a coil 18 is connected between the terminals 13 and 17 of the tweeter T and a capacitor 19 between the terminals 15 and 17 of woofer W. Other circuit elements such as the capacitor 12 and the coil 14 are of the same connection as the one shown in Fig. 1

The frequency bands in these circuits are divided by

the crossover frequency $f_0$, and the values of the capacitance $C_2$ of the capacitor 12 and the inductance $L_2$ of the coil 14 can be calculated by the following equations:

$$C_2 = \frac{\sqrt{2}}{4 \pi f_0 R_0} \qquad (F: \text{ Farad})$$

$$L_2 = \frac{\sqrt{2} \ R_0}{2 \pi f_0} \qquad (H: \text{ Henry})$$

wherein $f_0$: cross frequency (Hz)

$F_0$: impedance of each speaker ($\Omega$)

In this network, attenuation characteristics of octabe/12 db is obtained at the crossover frequency $f_0$.

It is necessary that the capacitor 19 which is connected in parallel to the terminal of woofer W in this circuit is provided with sufficient current capacity as compared to the power which the woofer W handles. The tone quality is known to improve when the capacitor on the woofer side shows a slightly greater dielectric loss as compared to the capacitor 12 inserted on the side of tweeter T. As for the coils 18 and 14, the coil 14 to be connected on the woofer side is inserted into an iron core to decrease the internal resistance of the coil.

Generally speaking, capacitor with a vapor metalized electrode is used more frequently for the purpose of making the dividing network compact. However, tone quality of the reproduced sound from the speaker has heretofore been degraded due to the distortion caused by the residual inductance inside, by the electric loss and non-linear characteristics in the vapor metalized electrode, or by the oscillation of the electrode layer as the audio signal passes.

As for the coil, although coil with hollow or iron core is often used, it oscillates as the audio signal passes, thereby degrading the tone quality of the reproduced sound. Also, the floating capacitance of the coil itself cannot be ignored.

The dividing network of the present invention is suitable for the dividing network of speaker system to reproduce acoustic sounds at low loss and high fidelity and of other electronic equipments.

Referring now to an embodiment of the present invention, Fig. 3 shows a member constituting the dividing network. The member which constitutes the network comprises a pair of dielectric members in the form of thin film 21a and 21b made of, for instance, polyethylene terephthalate, polypropylene and the like and a pair of high electro-conductive strips 22a and 22b made of, for instance, copper, which tightly interpose said dielectric members therebetween and are laminated to form a continuous strip-like network member 23. The strip-like network member 23 is wound about a bobbin of a suitable material (not shown in the figure) several or more times, forming lamination for the network element 24 which forms a distributed constant element as shown in Fig. 4. The member 23 is wound about the bobbin several to about two hundred times according to the equipment or device where it is employed.

In the network element 24 forming the distributed constant element, capacitance factor is provided by laminating the conductive strip members 22a and 22b via the dielectric members 21a and 21b and, at the same time, inductance factor is formed by winding those members. Characteristic impedance to be determined by the width of the strip members, and the thickness and dielectric constants of the dielectric members can thereby be arbitrarily selected. For instance, the inductance with impedance of 8 Ω which is widely used for speakers can be made to have approximately this value by winding a pair of copper strips of 40 m/m in width each and 20 μm in thickness via a pair of polyethlene telephthalate films of 9 μm in thickness each.

The capacitance element is constructed by leading out a terminal only from an end portion or other portion of the strip member of either 22a or 22b without influencing other characteristics of the network elements and inductance element is constructed by leading out terminals from the other both end portions of the strip members 22a and 22b to form a network element 24 where predetermined inductance and capacitance are integrated.

Namely, as shown in Fig. 5(A), terminals 27, 28 and 29 are led out respectively from the end portions 25b, 25a and 26a of the strip members that are selected out of the begining ends 25a and 25b and the other ends 26a and 26b of the winding strip-like network member 23. With the terminal 27 as signal input terminal, 28 as signal output terminal and 29 as common terminal, the equivalent circuit of the network element 24 or the distributed constant element is constructed as shown in Fig. 5(B). The terminal 29 led out from the end portion 26b of the strip member may otherwise be led out from other arbitray portion thereof, thereby obtaining substantially unchanged effect.

Tap 30 may be led out from, for instance, a portion of the strip member 22a as necessary.

Thus, in the network element 24 of the above-mentioned structure, as shown by its equivalent circuit, a high pass filter comprising the capacitor C and the inductance L is formed and a signal distribution circuit in respect of the tweeter is constructed by supplying audio signals to the input terminal 27. The voltage applied to the tweeter can be selected by setting up an arbitrary tap 30. The value of inductance can be adjusted by inserting iron core or the like into the network element, as the need be.

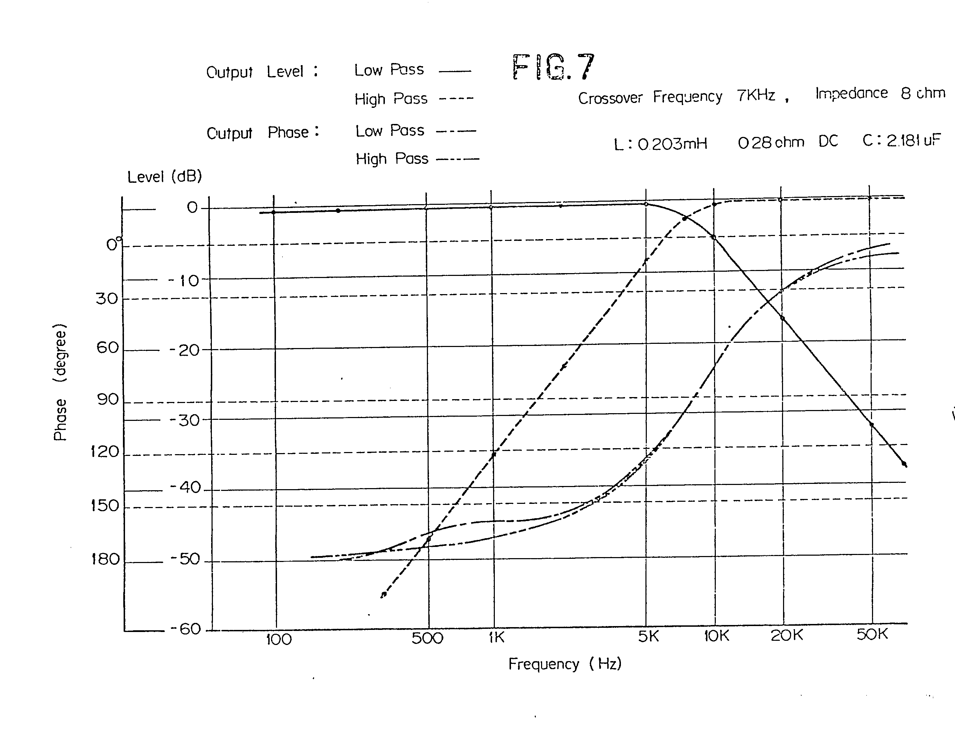

As shown in Fig. 6(A), when terminals 31, 32 and 33 are led out respectively from ends 25a, 26a and 26b of the strip-like network member 23 to form terminals 31 and 32 as signal input and output terminals and terminal 33 as a common terminal, its equivalent circuit becomes as shown in Fig. 6(B) to form low pass filter comprising the capacitance C and the inductance L so as to construct a signal distribution circuit in respect of the woofer. If the capacity of the capacitance C is insufficient, an electrolytic capacitor may be provided in parallel.

The terminal 31 led out from the end portion 25a of the strip member may otherwise be led out from other arbitrary portion thereof, thereby obtaining substantially unchanged effect.

Since, as described above, filter for both high and low passes can be readily constructed by utilizing the network element 24 according to this invention, the dividing network shown in Fig. 1 and Fig. 2 can be constructed by using the above element singly or in combination. Further, it will be easily understood that band pass and band elimination filters can be arbitrarily obtained by cascading network elements having different crossover frequency.

If the capacity of the capacitor C shown by the equivalent circuit is insufficient, it is possible to adjust it by supplying other suitable adding capacitor with low loss between the pair of the strip members 22a and 22b constituting the said network element 24. Tone quality or the like can be effectively compensated or adjusted by the loss of the said adding capacitor.

Further, the deviding network according to the present invention enables the production of a network compatible with, for instance, coaxial cable which is sophisticated and of low loss, used in electronic devices or communication equipments. If, in such case, styrol resin film which has the lowest loss rate in high frequency region is used as dielectric member, it can be integrated as one single body by heat-treatment after winding the strip members, thereby readily offering low loss network element having highpass and low-pass characteristics.

It can be easily understood that by combining the above elements, a network for band pass filter or band elmination filter could be obtained.

Fig. 7 shows the transmission characteristics of the network element of this invention at the crossover frequency of 7 KHz wherein an element is measured when connected as Figs. 5 and 6 indicate. The transmission characteristics here indicates substantially same attenuation characteristics of octabe/12 db around the cross frequency and its phase characteristics is excellent.

As revealed in the foregoing, in the dividing network of the present invention, floating capacity does not substantially exist in the inductance of the strip members of the distribution constant element which is a component of the network element and residue inductance does not substantially exist in the capacitance: therefore, the network element of this invention advantageously has remarkable frequency characteristics and transmitting characteristics and, on the other hand, the loss in the circuit is conveniently restricted to be small by utilizing conductive member as a conductor comprising the strip members. Moreover, the strip members are laminated tightly without leaving clearance inside as in the conventional case: therefore, neither oscillation nor noise factor is caused by the passing of signal current, thereby securing excellent inductance. Besides, it is capable to adjust tone quality so as to fit for division regions by selecting suitable materials for the dielectric member.

Shortly summarized the invention comprises a dividing network including a dividing network element 24 formed by winding a pair of strip members 22a, 22b of high electro-conductivity arranged opposedly to each other with a dielectric member 21a, 21b interposed therebetween, inductance formed in said wound strip members 22a, 22b, capacitance formed between said strip members 22a, 22b, and a plurality of terminals 27, 28, 29, 30 selectively led out from the end portions 25a, 25b, 26a or other portion of said pair of the strip members 22a, 22b.

Claims:

1. A dividing network characterized in that said dividing network comprises a dividing network element formed by winding a pair of strip members of high electro-conductivity arranged opposedly to each other with a dielectric member interposed therebetween, inductance formed in said wound strip members, capacitance formed between said strip members, and a plurality of terminals selectively led out from the end portions or other portion of said pair of the strip members.

2. A dividing network as claimed in Claim 1, wherein the plurality of terminals are selectively led out from either an end portion or an intermediate portion of said strip members.

3. A dividing network as claimed in Claim 1, wherein said pair of strip members of high electro-conductivity are wound several or more times around an iron core.

4. A dividing network as claimed in Claim 1, wherein said plurality of terminals is composed of at least one terminal led out from an end portion or other portion of either one of the pair of the strip members of high electro-conductivity and terminals led out from the other both end portions of the pair of the strip members.

5. A dividing network as claimed in Claim 1 or 4, wherein the values of the inductance which is formed by winding the pair of the strip members of high electro-conductivity and of the capacitance which is formed between the strip members are selected to fit to the impedance of either the line or the load at a predetermined crossover frequency.

$-1\frac{1}{3}$

**FIG.1**

**FIG.2**

**FIG.3**

(A)

(B)

**FIG.4**

FIG.5

(A)                          (B)

FIG.6

(A)                          (B)

Output Level : Low Pass ——
High Pass ----

Output Phase : Low Pass —·—
High Pass —··—

# FIG.7

Crossover Frequency 7KHz , Impedance 8 ohm

L : 0.203mH    0.28 ohm DC    C : 2.181 uF

Level (dB)

Phase (degree)

Frequency ( Hz)

0013392

European Patent Office

**EUROPEAN SEARCH REPORT**

Application number

EP 79 10 5269

| | DOCUMENTS CONSIDERED TO BE RELEVANT | | CLASSIFICATION OF THE APPLICATION (Int Cl |
|---|---|---|---|
| Category | Citation of document with indication. where appropriate. of relevant passages | Relevant to claim | |
| | FR - A - 2 249 489 (LABORATOIRE D'ELECTRONIQUE ET D'AUTOMATIQUE DAUPHINOIS, L.E.A.D. & MAYER) <br> * Page 2, line 2 - page 3, line 34; figures * <br><br> -- <br><br> US - A - 3 141 145 (W.P. BARRETT) <br> * Column 2, line 69 - column 4, line 35; figures * <br><br> -- <br><br> US - A - 2 027 067 (K. SCHUBERT) <br> * Page 1, right-hand column, lines 1-26; page 1, right-hand column, line 49 - page 2, left-hand column, line 14; page 2, right-hand column, lines 20-52; figures 2-5 * <br><br> -- | 1,4 <br><br><br><br><br><br> 1-4 <br><br><br><br><br> 1-4 | H 04 R 3/14 <br> H 03 H 3/00 <br><br><br><br><br><br><br><br><br><br><br> TECHNICAL FIELDS SEARCHED (Int.Cl. ') <br><br> H 04 R 3/14 <br> H 03 H 3/00 <br> H 03 H 7/32 <br> 7/34 |
| A | FUNKSCHAU, vol. 50, no. 20, September 1978, pages 969-972 München, DE. "Lautsprecherkombinationen - elektrische Weichen, Phasenfehler" <br> * Page 970, left-hand column, paragraph 1.2; figures 4,5 * <br><br> ---- | 1,5 | |

CATEGORY OF CITED DOCUMENTS

X: particularly relevant
A: technological background
O: non-written disclosure
P: intermediate document
T: theory or principle underlying the invention
E: conflicting application
D: document cited in the application
L: citation for other reasons

& member of the same patent family. corresponding document

The present search report has been drawn up for all claims

| Place of search | Date of completion of the search | Examiner |
|---|---|---|
| The Hague | | |